# FASCICULE DE BREVET EUROPEEN

(11) **EP 2 039 000 B1**
(45) Date de publication et mention de la délivrance du brevet: **02.11.2016**
(21) Numéro de dépôt: 07787111.9
(22) Date de dépôt: 05.07.2007
(51) Int. Cl.: H03F 3/193, H03F 1/22, H03F 3/60

(54) **DISPOSITIF D'AMPLIFICATION D'UN SIGNAL HYPERFREQUENCE A LARGE BANDE**
EINRICHTUNG ZUM VERSTÄRKEN EINES BREITBAND-HF-SIGNALS
DEVICE FOR AMPLIFYING A BROADBAND RF SIGNAL

(30) Priorité: 07.07.2006 FR 0606216
(43) Date de publication de la demande: 25.03.2009
(73) Titulaire: Thales, 92400 Courbevoie (FR)
(72) Inventeur: MALLET-GUY, Benoît, 75015 Paris (FR); DEQUEN, Thierry, 78990 ELANCOURT (FR)
(74) Mandataire: Lucas, Laurent Jacques
(86) Numéro de dépôt international: PCT/EP2007/056821
(87) Numéro de publication internationale: WO 2008/003751

(56) Documents cités:
- US-A- 4 409 557
- US-A1- 2004 150 478
- US-A1- 2006 119 435
- US-B1- 6 392 492

## Description

La présente invention concerne un dispositif d'amplification d'un signal hyperfréquence à large bande. Cette invention est utilisée notamment pour des récepteurs hyperfréquence, par exemple dans le cas de liaisons haut débit ou autres applications nécessitant une réception sur une large bande de fréquences.

Pour certaines applications, les récepteurs de signaux hyperfréquence possèdent des circuits de réception intégrés montant très haut en fréquence. Ces circuits de réception nécessitent des amplifications des signaux reçus. Des amplificateurs large bande sont donc utilisés. Ces amplificateurs, en plus d'être large bande, doivent posséder un gain élevé pour un facteur de bruit faible et être réalisés avec de faibles dimensions.

Parmi les amplificateurs large bande mis en oeuvre deux architectures sont notamment connues : une architecture distribuée et une architecture contre-réactionnée.

Des exemples peuvent être trouvés dans les documents de brevet US 2006/0119435 et US 4,409,557, respectivement.

L'amplificateur distribué possède une architecture permettant un fonctionnement sur une large bande. Les circuits utilisant cette architecture ont un gain de l'ordre de 10 dB pour un facteur de bruit de 4 à 5 dB en général. Une amélioration connue de cette structure consiste à remplacer chaque transistor de l'amplificateur par une cellule de type cascode. Une telle architecture permet d'obtenir un gain de l'ordre de 13 dB tout en augmentant le niveau de puissance du signal en sortie de l'amplificateur. Les principaux inconvénients de ce type d'architecture sont le niveau de bruit relativement élevé et la taille qui reste importante même en utilisant une technologie de circuit intégré monolithique micro-onde ou MMIC.

L'architecture contre-réactionnée consiste à insérer entre l'entrée et la sortie d'un transistor un circuit de type passe-bas. Cette architecture permet d'obtenir un gain constant sur une plage de fréquence. Une amélioration consiste à utiliser une cellule cascode à la place du transistor, ce qui permet d'avoir un gain de l'ordre de 13 dB pour un montage de taille réduite. Néanmoins un tel montage possède une largeur de bande de fréquence insuffisante et donc non adaptée à une application large bande.

Un but de l'invention est notamment de pallier les inconvénients précités. A cet effet, l'invention a pour objet un dispositif d'amplification d'un signal hyperfréquence comportant une cellule cascode. La cellule cascode comprend au moins deux transistors. La grille d'un premier transistor est reliée vers l'entrée dudit dispositif. Le drain du deuxième transistor est relié vers la sortie dudit dispositif. La source du deuxième transistor est reliée au drain du premier transistor.

Un circuit à impédance variable est connecté à la grille du deuxième transistor et varie en fonction de la fréquence du signal d'entrée.

Le circuit à impédance variable comporte une inductance et une résistance montées en séries, il est connecté entre la grille du deuxième transistor et un potentiel de référence.

Les transistors utilisés dans le dispositif peuvent être des transistors à effet de champ.

La cellule cascode étant contre-réactionnée, un filtre passe-bas est par exemple connecté entre l'entrée et la sortie du dispositif. Le filtre passe-bas comporte une inductance et une résistance montées en série. L'inductance comporte une partie fixe et une partie ajustable réalisées en technologie MMIC.

L'invention a notamment pour principaux avantages de réduire le coût d'une puce intégrant un amplificateur large bande, tout en ayant un fonctionnement très large bande associé à un gain positif et à un faible niveau de bruit.

D'autres caractéristiques et avantages de l'invention apparaîtront à l'aide de la description qui suit faite en regard des dessins annexés qui représentent :
- la figure 1 : un exemple d'un amplificateur distribué connu ;
- la figure 2 : un exemple d'architecture contre-réactionnée ;
- la figure 3 : un schéma d'une cellule cascode ;
- la figure 4 : un schéma de principe d'une cellule cascode contre-réactionnée selon l'art antérieur;
- la figure 5 : un premier exemple de réalisation d'un dispositif d'amplification selon l'invention ;
- la figure 6 : un deuxième exemple de réalisation une cellule cascode contre-réactionnée à impédance de grille variable selon l'invention ;
- les figures 7a et 7b : un exemple de réalisation d'un dispositif d'amplification selon l'invention.

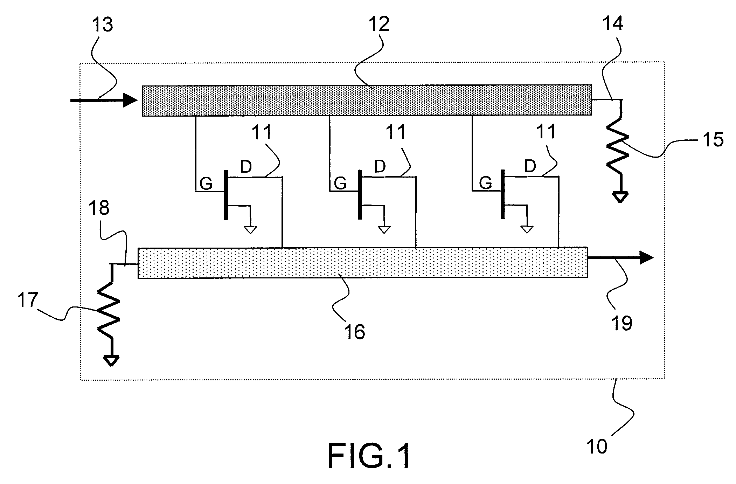

La figure 1 représente un schéma de principe d'un amplificateur 10 possédant une architecture distribuée selon l'art antérieur. Cet amplificateur distribué 10 comprend N cellules amplificatrices montées en parallèle, à base d'un ou plusieurs transistors à effet de champ. Dans l'exemple de la figure 1, chaque cellule amplificatrice comporte un transistor 11 qui peut être par exemple un transistor à effet de champ. La grille d'un transistor 11 est reliée à une ligne de grilles commune 12 qui s'étend d'un point d'entrée du montage 13 à un point d'accès 14 sur lequel est connectée une résistance 15 reliée à un potentiel de référence. Le drain du transistor 11 est relié à une ligne de drains commune 16 qui s'étend entre une résistance 17 et un point de sortie 19 du montage. La résistance 17 est montée sur un accès 18 de la ligne de drains 16 et reliée à un potentiel de référence. La source du transistor 11 est reliée au potentiel de référence. Par la suite le potentiel de référence sera assimilé au zéro électrique ou à la masse mécanique.

Les lignes de grilles 12 et de drains 16 sont des lignes composées essentiellement des capacités internes aux transistors et d'inductances éventuellement liées par des mutuelles inductances. Ces inductances sont notamment prévues pour adapter la ligne à une impédance caractéristique par exemple de 50 Ohms.

L'entrée de la ligne de grilles commune 12 forme l'entrée 13 de l'amplificateur distribué 10. L'autre extrémité 14 de la ligne de grilles est chargée sur une résistance terminale ou charge annexe 15 dont la valeur de résistance est sensiblement égale à l'impédance caractéristique de la ligne de grilles commune 12.

De même que sur la ligne de grilles 12, l'une des extrémités de la ligne de drains commune 16 est chargée sur une résistance terminale 17 dont la valeur de résistance est sensiblement égale à l'impédance caractéristique de la ligne de drains commune 16, tandis que l'autre extrémité de la ligne de drains commune 16 définit la sortie 19 de l'amplificateur distribué.

Un circuit de polarisation non représenté sur la figure 1 applique une tension de polarisation continue sur la ligne de grilles commune 12.

Le fonctionnement d'un amplificateur distribué du type de celui illustré sur la figure 1 est le suivant. Un signal hyperfréquence reçu en entrée 13 se propage sur la ligne de grilles commune 12 pour être absorbé par la charge annexe 15. Sur chaque grille de transistors 11 passe donc un signal, se propageant de l'entrée 13 vers la charge annexe 15. Ce signal se propage à travers les transistors 11 vers la sortie 19, l'autre extrémité de la ligne de drains 16 étant chargée par son impédance caractéristique. Ce signal hyperfréquence étant amplifié par les transistors 11, l'amplification est à très large bande passante car elle commence depuis le continu jusqu'aux fréquences de coupure liées aux caractéristiques des transistors 11. Ces fréquences de coupure peuvent être très hautes, de plusieurs dizaines de GHz, à la centaine de GHz.

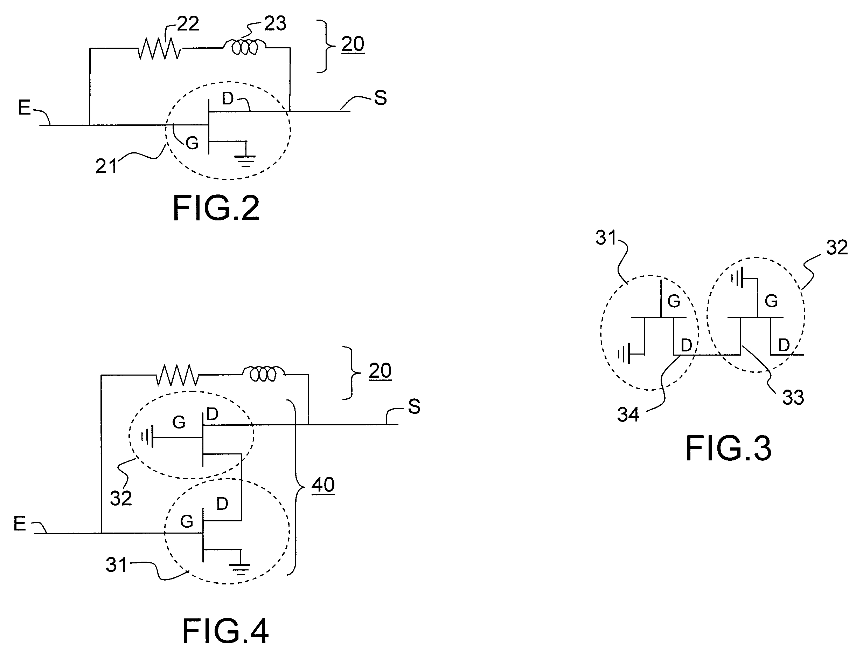

La figure 2 présente un exemple de circuit amplificateur selon une architecture contre-réactionnée. L'architecture contre-réactionnée consiste à insérer entre l'entrée E et la sortie S d'un ensemble de transistors 21 un circuit 20 formant un filtre passe-bas. Sur la figure 2 l'ensemble de transistors est représenté par un transistor 21, l'entrée du circuit E étant reliée à la grille G du transistor 21 et la sortie S du circuit étant reliée au drain D du transistor 21.

Dans l'exemple de la figure 2, le circuit de type passe-bas 20 est composé d'une inductance 23 et d'une résistance 22. La résistance 22 est reliée à l'entrée E du circuit et l'inductance 23 est reliée à la sortie S du circuit amplificateur.

Les signaux basses fréquences passent par le circuit de contre-réaction 20, formant le filtre passe-bas, et ne sont donc pas amplifiés. En revanche, les signaux hautes fréquences passent par le transistor 21 qui les amplifie. Une tension de polarisation continue est par ailleurs appliquée sur la grille G du transistor 21 pour le rendre passant.

La contre-réaction étant associée à la pente de gain inverse naturelle du transistor, il en résulte un gain assez constant sur la plage de fonctionnement du circuit amplificateur.

La largeur de bande de fréquence de fonctionnement d'une telle architecture est insuffisante pour une application large bande pour laquelle un rapport de l'ordre de 20 entre la fréquence minimum et la fréquence maximum est par exemple recherché.

La figure 3 présente le schéma d'une cellule cascode connue. Cette cellule cascode peut être utilisée pour améliorer les performances des deux architectures présentées précédemment. En effet, elle permet dans les deux cas d'obtenir un gain plus élevé, supérieur à 10 dB.

Cette cellule cascode comporte par exemple deux transistors à effet de champ 31 et 32, le deuxième transistor 32 ayant sa source 33 connectée au drain 34 du premier transistor 31. La source du transistor 31 et la grille du transistor 32 sont reliées à un potentiel de référence. Un circuit de polarisation non représenté applique une tension continue aux grilles des transistors 31 et 32 afin de rendre ces derniers passant.

La figure 4 représente une cellule cascode utilisée dans une architecture contre-réactionnée, le tout formant un circuit amplificateur selon l'art antérieur. Ce circuit comporte donc une cellule cascode 40 telle que décrite figure 3, et un circuit passe-bas 20 tel que décrit au niveau de la figure 2. L'entrée E du circuit amplificateur est reliée à la grille du transistor 31 et la sortie S du circuit est reliée au drain du transistor 32.

Cette architecture possède un encombrement très restreint ainsi qu'un gain élevé, supérieur à 10 dB. Néanmoins un tel circuit ne possède pas encore une largeur de bande suffisamment étendue.

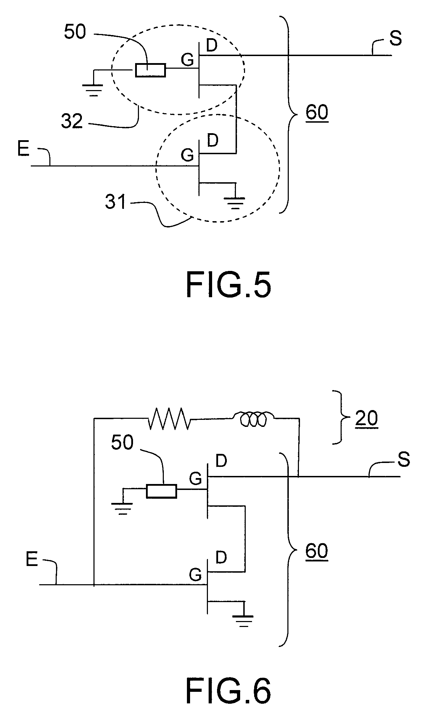

La figure 5 représente un exemple de réalisation d'un dispositif d'amplification selon l'invention. Ce dispositif comporte une cellule cascode 60 du type de celle décrite sur la figure 3. L'entrée du signal dans la cellule cascode selon l'invention se fait sur la grille du transistor 31, le signal sortant par le drain du transistor 32. Selon l'invention, un circuit à impédance variable 50 est connecté entre la grille G du deuxième transistor 32 et le potentiel de référence, par exemple la masse mécanique ou le zéro électrique. L'impédance variable du circuit 50 est fonction de la fréquence du signal reçu. Cette impédance peut varier de manière linéaire ou pseudo-linéaire en fonction de la fréquence. Le circuit à impédance variable 50 se comporte comme un circuit contre-réactionné permettant ainsi d'élargir la bande de fréquence de la cellule cascode. En particulier, il est possible de régler la pente de gain, positive ou négative, du dispositif selon la valeur choisie de l'impédance. Le circuit à impédance variable 50 peut participer au fonctionnement alternatif du transistor 32 en apportant un degré de réglage supplémentaire à la cellule cascode 60 permettant ainsi d'élargir la bande de fréquence de fonctionnement.

La figure 6 présente un autre exemple de réalisation d'un dispositif selon l'invention. Dans cet exemple, le dispositif comporte une contre-réaction telle que représenté sur la figure 4, utilisant la cellule cascode 60 selon l'invention décrite au niveau de la figure 5. Cette cellule cascode 60 est associée à un filtre passe-bas 20. La contre-réaction appliquée à la cellule cascode à impédance variable ajoute au circuit amplificateur de la figure 5 les avantages d'un amplificateur contre-réactionné. Le circuit contre-réactionné 20 est mis à profit afin d'élargir la bande de fréquence de fonctionnement du circuit amplificateur utilisant la cellule cascode 60 selon l'invention. Le circuit amplificateur, ou cellule cascode contre-réactionnée à impédance de grille variable, est donc un circuit large bande. L'effet de contre-réaction, apporté par l'invention, lié à l'impédance de grille variable, permet un paramètre supplémentaire de conception de circuit sur lequel on peut agir pour augmenter la bande de fréquence de fonctionnement du circuit. Ce circuit amplificateur permet d'obtenir les mêmes bandes passantes que celles habituellement obtenues avec une architecture distribuée telle que sur la figure 1 par exemple. Mise en oeuvre avec une technologie MMIC, la cellule cascode selon l'invention permet de réduire d'un facteur deux la taille d'un amplificateur large bande.

Les performances en bruit sont également améliorées puisque le facteur de bruit maximum d'un amplificateur distribué, du type de celui représenté sur la figure 4 par exemple, est typiquement de 4 dB à comparer au 2,5 dB de la cellule cascode contre-réactionnée à impédance de grille variable selon l'invention.

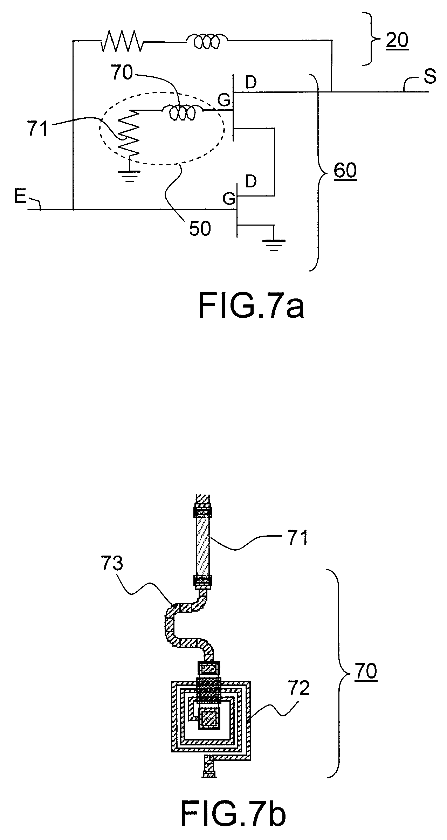

Les figures 7a et 7b présentent un mode de réalisation possible d'un dispositif selon l'invention.

La figure 7a présente une réalisation du circuit à impédance variable 50 en technologie MMIC. Dans l'exemple de la figure 7a, le circuit à impédance variable est composé d'une inductance 70 et d'une résistance 71. Dans un circuit intégré hyperfréquence, l'impédance variable 50 du circuit peut être facilement synthétisée par une résistance 71 de forte valeur, par exemple 2kΩ, montée en série avec une petite inductance 70. La résistance 71 est elle-même reliée à un potentiel de référence, tel qu'illustré par la figure 7a. La figure 7b montre un exemple d'implantation d'un circuit à impédance variable sur un masque d'un amplificateur non représenté utilisant la technologie MMIC. Le circuit à impédance variable 50 représenté schématiquement sur la figure 7a se retrouve sur le masque avec la résistance 71 et l'inductance 70. Sur ce masque, l'inductance 70 est composée d'une partie fixe 73 et d'une partie ajustable 72. La partie fixe 73 est par exemple formée par un enroulement de pistes conductrices formant des carrés concentriques. Entre la résistance 71 et l'inductance fixe 73 se trouve une ligne 72 qui permet d'ajuster la valeur de l'inductance 70. Cette valeur est ajustée en jouant sur la longueur de cette ligne 72.

La présente invention peut notamment être utilisée afin de réaliser des amplificateurs large bande avec une pente de gain positive, qui peuvent trouver leur application dans une chaîne ou un système hyperfréquence large bande, notamment en réception.

La réalisation d'un amplificateur avec un circuit comprenant une seule cellule cascode permet de réduire considérablement la taille du circuit intégré dans lequel la cellule cascode selon l'invention est implantée. Sachant que le coût de fabrication d'un circuit intégré est directement lié à sa surface, l'invention permet de réduire le coût de fabrication de l'amplificateur.

La cellule cascode à impédance de grille variable selon l'invention utilisée dans une architecture contre-réactionnée permet avantageusement d'obtenir un amplificateur très large bande ayant un facteur de bruit relativement faible et un gain élevé.

## Revendications

1. Dispositif d'amplification d'un signal hyperfréquence comportant une cellule cascode (60) comprenant au moins deux transistors (31,32), la grille d'un premier transistor (31) étant reliée vers l'entrée (E) dudit dispositif, le drain du deuxième transistor (32) étant relié vers la sortie (S) dudit dispositif, la source du deuxième transistor (32) étant reliée au drain du premier transistor (31), chaque transistor (31, 32) comportant sur sa grille un circuit de polarisation, **caractérisé en ce qu'**un circuit à impédance variable (50), comportant une inductance (70) et une résistance (71) montées en séries, est connecté à la grille du deuxième transistor (32) et configuré pour permettre d'élargir la bande de fréquence de fonctionnement du dispositif.

2. Dispositif selon la revendication 1, **caractérisé en ce que** l'impédance du circuit à impédance variable (50) varie en fonction de la fréquence du signal d'entrée (E).

3. Dispositif selon l'une quelconque des revendications précédentes, **caractérisé en ce que** le circuit à impédance variable (50) est connecté entre la grille du deuxième transistor (32) et un potentiel de référence.

4. Dispositif selon l'une quelconque des revendications précédentes, **caractérisé en ce que** les transistors (31,32) sont à effet de champ.

5. Dispositif selon l'une quelconque des revendications précédentes, **caractérisé en ce que** la cellule cascode (60) est contre-réactionnée, un filtre passe-bas (20) étant connecté entre l'entrée (E) et la sortie (S) du dispositif.

6. Dispositif selon la revendication 5, **caractérisé en ce que** le filtre passe-bas (20) comporte une inductance et une résistance montées en série.

7. Dispositif selon la revendication 6, **caractérisé en ce que** l'inductance comporte une partie fixe (72) et une partie ajustable (73) réalisées en technologie MMIC.

## Patentansprüche

1. Vorrichtung zur Verstärkung eines HF-Signals, umfassend eine Kaskodeneinheit (60) mit mindestens zwei Transistoren (31, 32), wobei der Gate-Anschluss eines ersten Transistors (31) mit dem Eingang (E) der Vorrichtung verbunden ist, der Drain-Anschluss des zweiten Transistors (32) mit dem Ausgang (S) der Vorrichtung verbunden ist, der Source-Anschluss des zweiten Transistors (32) mit dem Drain-Anschluss des ersten Transistors (31) verbunden ist, jeder Transistor (31, 32) an seinem Gate-Anschluss eine Vorspannungsschaltung aufweist, **dadurch gekennzeichnet, dass** eine Schaltung mit variabler Impedanz (50), umfassend einen Induktor (70) und einen Widerstand (71), die in Reihe geschaltet sind, an den Gate-Anschluss des zweiten Transistors (32) angeschlossen und dafür konfiguriert ist, eine Erweiterung der Betriebsbandbreite der Vorrichtung zu ermöglichen.

2. Vorrichtung nach Anspruch 1, **dadurch gekennzeichnet, dass** die Impedanz der Schaltung mit variabler Impedanz (50) in Abhängigkeit von der Frequenz des Eingangssignals (E) variiert.

3. Vorrichtung nach einem der vorhergehenden Ansprüche, **dadurch gekennzeichnet, dass** die Schaltung mit variabler Impedanz (50) zwischen den Gate-Anschluss des zweiten Transistors (32) und ein Bezugspotential geschaltet ist.

4. Vorrichtung nach einem der vorhergehenden Ansprüche, **dadurch gekennzeichnet, dass** die Transistoren (31, 32) Feldeffekttransistoren sind.

5. Vorrichtung nach einem der vorhergehenden Ansprüche, **dadurch gekennzeichnet, dass** die Kaskodeneinheit (60) gegengekoppelt ist, wobei ein Tiefpassfilter (20) zwischen den Eingang (E) und dem Ausgang (S) der Vorrichtung geschaltet ist.

6. Vorrichtung nach Anspruch 5, **dadurch gekennzeichnet, dass** der Tiefpassfilter (20) einen Induktor und einen Widerstand umfasst, die in Reihe geschaltet sind.

7. Vorrichtung nach Anspruch 6, **dadurch gekennzeichnet, dass** der Induktor einen festen Teil (72) und einen justierbaren Teil (73) umfasst, deren Aufbau der MMIC-Technologie entspricht.

## Claims

1. A device for amplifying a high-frequency signal comprising a cascode cell (60) that comprises at least two transistors (31, 32), the gate of a first transistor (31) being connected to the input (E) of said device, the drain of the second transistor (32) being connected to the output (S) of said device, the source of said second transistor (32) being connected to the drain of said first transistor (31), each transistor (31, 32) comprising a bias circuit on its gate, **characterised in that** a variable-impedance circuit (50) that comprises an inductor (70) and a resistor (71) mounted in series is connected to the gate of said second transistor (32) and is configured to allow the operating frequency band of the device to be broadened.

2. The device according to claim 1, **characterised in that** the impedance of said variable-impedance circuit (50) varies as a function of the frequency of said input signal (E).

3. The device according to any one of the preceding claims, **characterised in that** said variable-impedance circuit (50) is connected between the gate of said second transistor (32) and a reference potential.

4. The device according to any one of the preceding claims, **characterised in that** said transistors (31, 32) are field-effect transistors.

5. The device according to any one of the preceding claims, **characterised in that** said cascode cell (60) is a feedback cell, with a low-pass filter (20) being connected between said input (E) and said output (S) of said device.

6. The device according to claim 5, **characterised in that** said low-pass filter (20) comprises an inductor and a resistor mounted in series.

7. The device according to claim 6, **characterised in that** said inductor comprises a fixed part (72) and an adjustable part (73) made using MMIC technology.
